# EUROPÄISCHE PATENTSCHRIFT

(11) **EP 2 684 249 B1**
(45) Veröffentlichungstag und Bekanntmachung des Hinweises auf die Patenterteilung: **28.11.2018**
(21) Anmeldenummer: 11772927.7
(22) Anmeldetag: 13.10.2011
(51) Int. Cl.: H01P 5/12, H05H 7/00, H03B 5/18, H03B 9/14, H01P 5/107

(54) **HF-GENERATOR**
RF GENERATOR
GÉNÉRATEUR HAUTE FRÉQUENCE

(30) Priorität: 04.05.2011 DE 102011075219
(43) Veröffentlichungstag der Anmeldung: 15.01.2014
(73) Patentinhaber: Siemens Aktiengesellschaft, 80333 München (DE)
(72) Erfinder: HEID, Oliver, 91052 Erlangen (DE); HUGHES, Timothy, 91056 Erlangen (DE)
(86) Internationale Anmeldenummer: PCT/EP2011/067904
(87) Internationale Veröffentlichungsnummer: WO 2012/149986

(56) Entgegenhaltungen:
- EP-A1- 2 502 470
- US-A- 4 234 854
- US-A- 4 283 685
- US-A- 5 084 682
- US-A1- 2007 229 182
- HEID O ET AL: "Compact Solid State Direct drive RF Linac", PROCEEDINGS OF IPAC (2010) KYOTO, JAPAN, , 23. Mai 2010 (2010-05-23), Seiten 4278-4280, XP002658698, ISBN: 978-92-9083-352-9 Gefunden im Internet: URL:http://accelconf.web.cern.ch/AccelConf /IPAC10/papers/thpd002.pdf [gefunden am 2011-09-08]

## Beschreibung

Die vorliegende Erfindung betrifft einen HF-Generator gemäß Patentanspruch 1 sowie einen Teilchenbeschleuniger mit einem HF-Generator gemäß Patentanspruch 16. Es ist bekannt, HF-Leistung mit Tetroden, Klystrons oder anderen Vorrichtungen zu erzeugen. Es ist ferner bekannt, HF-Leistung mit Wellenleitern, beispielsweise mit Hohlleitern, zu führen. Bisherige Lösungen sehen vor, die HF-Leistung an einem ersten Ort zu erzeugen und dann mittels eines Wellenleiters an einen zweiten Ort zu transportieren, wo die HF-Leistung, beispielsweise mittels eines Dämpfungsglieds oder eines induktiven Kopplers, beispielsweise in eine Kavität eingekoppelt wird. Bei einer solchen Anordnung treten an den Koppelstellen jedoch notwendigerweise Leistungsverluste auf. Außerdem weisen derartige Anordnungen einen hohen Platzbedarf auf.
Es ist außerdem bekannt, HF-Kavitäten mit integrierten Antriebsvorrichtungen zu versehen, um eine hochfrequente elektromagnetische Schwingung in der Kavität anzuregen. Eine solche HF-Kavität ist beispielsweise in der EP 0 606 870 A1 beschrieben. Das Dokument EP 2 502 470 A1 offenbart einen HF-Generator mit einer Kavität mit einer leitfähigen Wandung, wobei die Wandung einen ersten Schlitz aufweist,wobei ein erster Festkörperschalter über dem ersten Schlitz angeordnet ist, um eine hochfrequente elektrische Spannung über den ersten Schlitz anzulegen. Aufgabe der vorliegenden Erfindung ist es, eine Vorrichtung bereitzustellen, bei der die Erzeugung von HF-Leistung und die Weiterleitung der erzeugten HF-Leistung durch dieselbe Vorrichtung geleistet werden. Diese Aufgabe wird durch einen HF-Generator mit den Merkmalen des Patentanspruchs 1 gelöst. Es ist außerdem Aufgabe der vorliegenden Erfindung, einen Teilchenbeschleuniger mit einem derartigen HF-Generator bereitzustellen. Diese Aufgabe wird durch einen Teilchenbeschleuniger mit den Merkmalen des Patentanspruchs 16 gelöst. Bevorzugte Weiterbildungen sind in den abhängigen Ansprüchen angegeben.

Ein erfindungsgemäßer HF-Generator umfasst einen Hohlleiter mit einer leitfähigen Wandung, die einen ersten Schlitz aufweist. Dabei ist ein erster Festkörperschalter über dem ersten Schlitz angeordnet, um eine hochfrequente elektrische Spannung über den ersten Schlitz anzulegen. Vorteilhafterweise wird bei diesem HF-Generator die HF-Leistung direkt im die HF-Leistung transportierenden Hohlleiter angeregt. Dadurch reduzieren sich die Komplexität und die Herstellungskosten des HF-Generators. Ein weiterer Vorteil besteht in der Verwendung des Festkörperschalters, der gegenüber herkömmlichen Vorrichtungen zur Erzeugung von HF-Leistung eine erhöhte Flexibilität bietet und dabei kompakter und kostengünstiger ausgeführt werden kann.

Bevorzugt weist der Hohlleiter einen kreisförmigen Querschnitt auf. Vorteilhafterweise weisen Hohlleiter mit kreisförmigem Querschnitt besonders geeignete Schwingungsmoden auf.

In einer anderen Ausführungsform weist der Hohlleiter einen rechteckigen Querschnitt auf. Vorteilhafterweise sind auch Hohlleiter mit rechteckigem Querschnitt gut zur Übertragung von HF-Schwingungen geeignet.

Bevorzugt ist der HF-Generator ausgebildet, eine TE10-Schwingungsmode in dem Hohlleiter anzuregen.

Es ist zweckmäßig, dass der erste Festkörperschalter in einem Schirmgehäuse angeordnet ist. Vorteilhafterweise wird dadurch eine Abstrahlung von HF-Leistung reduziert.

In einer Weiterbildung des HF-Generators umfasst dieser eine Phasenkontrolleinrichtung, die dazu ausgebildet ist, ein erstes Phasenkontrollsignal zu erzeugen. Dabei ist der HF-Generator außerdem ausgebildet, dem ersten Festkörperschalter das erste Phasenkontrollsignal zuzuführen. Vorteilhafterweise kann der Festkörperschalter die ausgegebene hochfrequente elektrische Spannung dann mit dem Phasenkontrollsignal synchronisieren.

In einer bevorzugten Ausführungsform des HF-Generators ist ein zweiter Festkörperschalter über dem ersten Schlitz angeordnet. Vorteilhafterweise kann dann mehr HF-Leistung erzeugt werden. Es ist auch möglich, noch weitere Festkörperschalter parallel zu erstem und zweitem Festkörperschalter über dem ersten Schlitz anzuordnen, um die erzeugte HF-Leistung weiter zu erhöhen.

Bevorzugt sind der erste und der zweite Festkörperschalter in einem gemeinsamen Schirmgehäuse angeordnet. Vorteilhafterweise wird durch das Schirmgehäuse dann die durch die Festkörperschalter abgestrahlte HF-Leistung reduziert.

Es ist zweckmäßig, dass der HF-Generator ausgebildet ist, auch dem zweiten Festkörperschalter das erste Phasenkontrollsignal zuzuführen. Vorteilhafterweise können der erste und der zweite Festkörperschalter dann synchron zueinander und zum Phasenkontrollsignal HF-Leistung in den Hohlleiter einkoppeln.

In einer Weiterbildung des HF-Generators weist die Wandung einen zweiten Schlitz auf, wobei ein dritter Festkörperschalter über dem zweiten Schlitz angeordnet ist. Vorteilhafterweise lässt sich auch dadurch die mit dem HF-Generator erzeugbare HF-Leistung erhöhen.

In einer alternativen Ausführungsform des HF-Generators ist ein dritter Festkörperschalter über dem ersten Schlitz angeordnet. Vorteilhafterweise kann auch dadurch die mit dem HF-Generator erzeugbare HF-Leistung erhöht werden.

Es ist zweckmäßig, dass der dritte Festkörperschalter in einem zweiten Schirmgehäuse angeordnet ist. Vorteilhafterweise wird dann auch die durch den dritten Festkörperschalter abgestrahlte HF-Leistung reduziert.

In einer zusätzlichen Weiterbildung des HF-Generators ist die Phasenkontrolleinrichtung ferner ausgebildet, ein zweites Phasenkontrollsignal zu erzeugen, wobei der HF-Generator ausgebildet ist, dem dritten Festkörperschalter das zweite Phasenkontrollsignal zuzuführen. Vorteilhafterweise kann der zweite Festkörperschalter dann eine zum zweiten Phasenkontrollsignal synchrone hochfrequente elektrische Spannung ausgeben.

Besonders zweckmäßig ist, wenn die Phasenkontrolleinrichtung ausgebildet ist, das erste Phasenkontrollsignal und das zweite Phasenkontrollsignal mit einer Phasenverschiebung von 180° zueinander zu erzeugen.

In einer Weiterbildung des HF-Generators ist der Hohlleiter an eine Kavität gekoppelt. Vorteilhafterweise kann die durch den HF-Generator erzeugte HF-Leistung dann über den Hohlleiter in die Kavität geleitet werden.

Ein erfindungsgemäßer Teilchenbeschleuniger weist einen HF-Generator der vorgenannten Art auf. Vorteilhafterweise kann die durch den HF-Generator erzeugte HF-Leistung dann zur Beschleunigung geladener Teilchen verwendet werden.

Die Erfindung wird nun anhand der beigefügten Figuren näher erläutert. Dabei zeigen:
- Figur 1: eine erste perspektivische Darstellung eines HF-Generators gemäß einer ersten Ausführungsform;
- Figur 2: eine zweite perspektivische Darstellung des HF-Generators der ersten Ausführungsform;
- Figur 3: eine Schnittdarstellung des HF-Generators der ersten Ausführungsform;
- Figur 4: eine Aufsicht auf den HF-Generator der ersten Ausführungsform;
- Figur 5: eine erste perspektivische Darstellung eines HF-Generators gemäß einer zweiten Ausführungsform;
- Figur 6: eine zweite perspektivische Darstellung des HF-Generators der zweiten Ausführungsform;
- Figur 7: eine Schnittdarstellung des HF-Generators der zweiten Ausführungsform; und
- Figur 8: eine Aufsicht auf den HF-Generator der zweiten Ausführungsform.

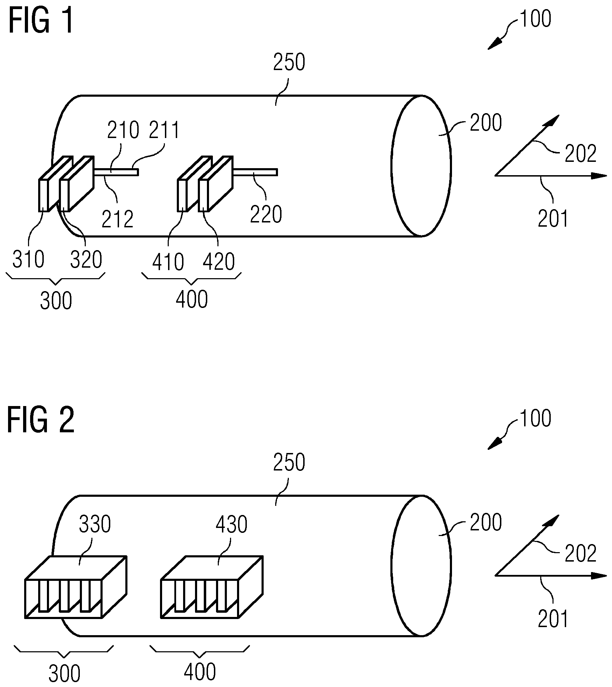

Figur 1 zeigt eine schematische perspektivische Darstellung eines HF-Generators 100 gemäß einer ersten Ausführungsform. Der HF-Generator 100 dient zur Erzeugung hochfrequenter elektromagnetischer Wellen mit hoher Leistung. Die durch den HF-Generator 100 erzeugte HF-Leistung kann beispielsweise in einem Teilchenbeschleuniger zur Beschleunigung geladener Teilchen genutzt werden.

Der HF-Generator 100 umfasst einen Hohlleiter 200. Der Hohlleiter 200 ist im Wesentlichen hohlzylindrisch ausgebildet und besteht aus einem elektrisch leitenden Material, bevorzugt aus einem Metall. Die axiale Richtung des zylindrischen Hohlleiters 200 legt eine Längsrichtung 201 fest. Senkrecht zur Längsrichtung 201 erstreckt sich eine radiale Richtung 202. Der Hohlleiter 200 weist einen kreisförmigen Querschnitt auf. Der Hohlleiter 200 könnte jedoch auch einen elliptischen oder einen anderen Querschnitt aufweisen.

Eine Mantelfläche des zylindrischen Hohlleiters 200 wird durch eine Wandung 250 gebildet. Wird in dem Hohlleiter 200 eine elektromagnetische Schwingungsmode angeregt, so fließen in der Wandung 250 orts- und zeitabhängige elektrische Ströme. Der räumliche und zeitliche Verlauf dieser elektrischen Ströme hängt von der im Hohlleiter 200 angeregten Schwingungsmode ab, lässt sich berechnen und ist unter Fachleuten bekannt.

Die Wandung 250 des Hohlleiters 200 des HF-Generators 100 weist einen ersten Schlitz 210 und einen zweiten Schlitz 220 auf. Die Schlitze 210, 220 sind an Positionen der Wandung 250 angeordnet, an denen ein großer elektrischer Strom fließt, wenn im Hohlleiter 200 eine gewünschte Schwingungsmode angeregt ist. Der Verlauf der Schlitze 210, 220 ist dabei senkrecht zur Richtung des Stromflusses orientiert. Im dargestellten Beispiel sind die Schlitze 210, 220 parallel zur Längsrichtung 201 orientiert. Die Schlitze 210, 220 könnten jedoch auch anders orientiert sein.

Am ersten Schlitz 210 in der Wandung 250 des Hohlleiters 200 ist eine erste Gruppe 300 von Festkörperschaltern angeordnet. Im dargestellten Beispiel umfasst die erste Gruppe 300 einen ersten Festkörperschalter 310 und einen zweiten Festkörperschalter 320. Die erste Gruppe 300 könnte jedoch auch lediglich einen Festkörperschalter 310 umfassen. In der Regel wird die erste Gruppe 300 jedoch mindestens zwei Festkörperschalter 310, 320 umfassen.

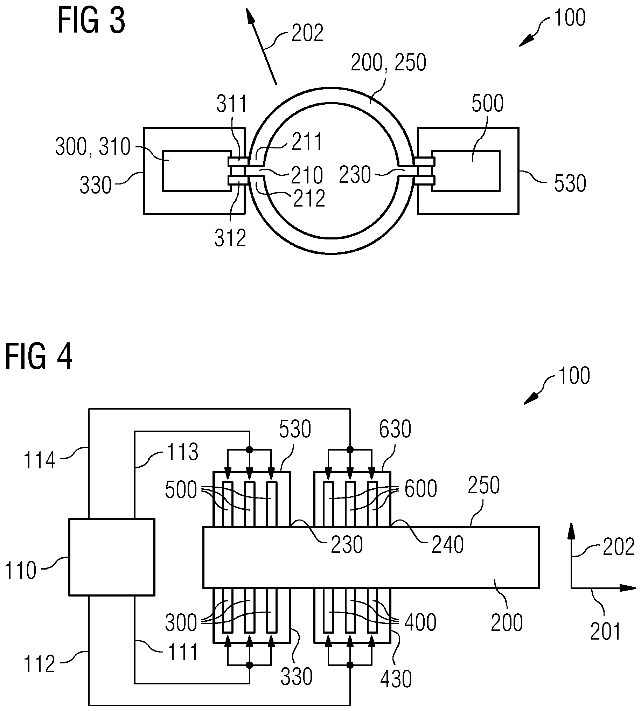

Die Festkörperschalter 310, 320 weisen jeweils einen ersten Ausgangsanschluss 311 und einen zweiten Ausgangsanschluss 312 auf (Figur 3) und sind dazu ausgebildet, zwischen den Ausgangsanschlüssen 311, 312 eine hochfrequente elektrische Spannung anzulegen und einen hochfrequenten elektrischen Strom zu schalten. Die Festkörperschalter 310, 320 können hierzu beispielsweise Festkörpertransistoren aufweisen. Die Festkörperschalter 310, 320 können jedoch auch anders aufgebaut sein. Der Begriff Festkörperschalter ist in diesem Sinne nicht einschränkend zu verstehen.

Der erste Festkörperschalter 310 und der zweite Festkörperschalter 320 sind jeweils so elektrisch leitend mit einem Abschnitt der Wandung 250 auf einer ersten Seite 211 des ersten Schlitzes 210 und einem Abschnitt der Wandung 250 auf einer zweiten Seite 212 des ersten Schlitzes 210 verbunden, dass die Festkörperschalter 310, 320 eine hochfrequente elektrische Spannung über den ersten Schlitz 210 anlegen können. Dadurch können in der Wandung 250 fließende elektrische Ströme angeregt werden, die wiederum eine Schwingungsmode im Hohlleiter 200 anregen.

Über dem zweiten Schlitz 220 der Wandung 250 des Hohlleiters 200 des HF-Generators 100 ist eine zweite Gruppe 400 von Festkörperschaltern angeordnet, die im dargestellten Beispiel einen dritten Festkörperschalter 410 und einen vierten Festkörperschalter 420 umfasst. Auch die zweite Gruppe 400 kann mehr oder weniger als zwei Festkörperschalter 410, 420 umfassen. Auch mittels der Festkörperschalter 410, 420 der zweiten Gruppe 400 können elektrische Ströme in der Wandung 250 des Hohlleiters 200 angeregt werden, die wiederum eine Schwingungsmode im Hohlleiter 200 anregen.

In der in Figur 4 gezeigten Aufsicht auf den HF-Generator 100 ist erkennbar, dass die Wandung 250 des Hohlleiters 200 des HF-Generators 100 einen in Figur 1 nicht sichtbaren dritten Schlitz 230 und einen in Figur 1 nicht sichtbaren vierten Schlitz 240 aufweist. Der dritte Schlitz 230 liegt dem ersten Schlitz 210 in radialer Richtung 202 gegenüber. Der vierte Schlitz 240 liegt dem zweiten Schlitz 230 in radialer Richtung 202 gegenüber. Über dem dritten Schlitz 230 ist eine dritte Gruppe 500 von Festkörperschaltern angeordnet. Über dem vierten Schlitz 240 ist eine vierte Gruppe 600 von Festkörperschaltern angeordnet.

Die Wandung 250 des Hohlleiters 200 kann weitere Schlitze umfassen, über denen jeweils ebenfalls Gruppen von Festkörperschaltern angeordnet sind. Alle Schlitze sind dabei so an der Wandung 250 des Hohlleiters 200 angeordnet, dass mit den Festkörperschaltern Ströme in der Wandung 250 angeregt werden können, die zur Anregung der gewünschten Schwingungsmode im Hohlleiter 200 führen.

Figur 2 zeigt eine weitere schematische perspektivische Darstellung des HF-Generators 100. Figur 2 zeigt, dass die erste Gruppe 300 von Festkörperschaltern 310, 320 am ersten Schlitz 210 der Wandung 250 des Hohlleiters 200 in einem ersten Schirmgehäuse 330 angeordnet ist. Entsprechend sind die Festkörperschalter 410, 420 der zweiten Gruppe 400 in einem zweiten Schirmgehäuse 430 angeordnet. Die Schirmgehäuse 330, 430 bestehen aus einem elektrisch leitenden Material, bevorzugt aus einem Metall. Die Schirmgehäuse sind elektrisch leitend mit der Wandung 250 verbunden und dienen dazu, eine durch die Festkörperschalter 310, 320, 410, 420 abgestrahlte elektromagnetische Leistung abzuschirmen. Dadurch reduzieren sich die Abstrahlungsverluste des HF-Generators 100. Außerdem reduziert sich dadurch ein möglicher Störeinfluss des HF-Generators 100 auf andere Geräte in der Umgebung des HF-Generators 100.

In der schematischen Darstellung der Figur 2 sind die Schirmgehäuse 330, 430 in radiale Richtung 202 außen geöffnet. Diese Darstellung wurde jedoch lediglich der Übersichtlichkeit halber gewählt. Bevorzugt umschließen die Schirmgehäuse 330, 430 die Festkörperschalter 310, 320, 410, 420 vollständig.

Die über dem dritten Schlitz 230 angeordnete dritte Gruppe 500 von Festkörperschaltern befindet sich in einem dritten Schirmgehäuse 530. Die über dem vierten Schlitz 240 angeordnete vierte Gruppe 600 von Festkörperschaltern befindet sich in einem vierten Schirmgehäuse 630.

Figur 3 zeigt in schematischer Darstellung einen zur Längsrichtung 201 senkrechten Schnitt durch den HF-Generator 100. Erkennbar ist der als Hohlzylinder ausgebildete Hohlleiter 200 mit seiner Wandung 250. Die Wandung 250 weist den ersten Schlitz 210 und den dritten Schlitz 230 auf. Der dritte Schlitz 230 liegt dem ersten Schlitz 210 in radialer Richtung 202 gegenüber.

Über dem ersten Schlitz 210 ist die erste Gruppe 300 von Festkörperschaltern 310, 320 angeordnet. Die erste Gruppe 300 von Festkörperschaltern 310, 320 ist in dem ersten Schirmgehäuse 330 angeordnet. Sichtbar ist lediglich der erste Festkörperschalter 310. Der erste Festkörperschalter 310 weist einen ersten Ausgangsanschluss 311 und einen zweiten Ausgangsanschluss 312 auf. Der erste Ausgangsanschluss 311 ist leitend mit einem Abschnitt der Wandung 250 auf der ersten Seite 211 des ersten Schlitzes 210 verbunden, während der zweite Ausgangsanschluss 312 elektrisch leitend mit einem Abschnitt der Wandung 250 auf der zweiten Seite 212 des ersten Schlitzes 210 verbunden ist. Der zweite Festkörperschalter 320 und alle weiteren Festkörperschalter der ersten Gruppe 300 weisen entsprechende Ausgangsanschlüsse 311, 312 auf, die entsprechend mit der Wandung 250 verbunden sind. Die gilt auch für die Festkörperschalter der übrigen Gruppen 400, 500, 600.

Figur 4 zeigt eine schematische Aufsicht auf den HF-Generator 100. Erkennbar ist der Hohlleiter 200 mit der ersten Gruppe 300 von Festkörperschaltern 310, 320, der zweiten Gruppe 400 von Festkörperschaltern 410, 420, der dritten Gruppe 500 von Festkörperschaltern und der vierten Gruppe 600 von Festkörperschaltern.

Es wurde bereits ausgeführt, dass die in der Wandung 250 des Hohlleiters 200 fließenden elektrischen Ströme orts- und zeitabhängig sind. Die an den Orten der Schlitze 210, 220, 230, 240 der Wandung 250 fließenden elektrischen Ströme weisen daher zu jedem Zeitpunkt voneinander abweichende Phasenlagen auf. Daher müssen die Gruppen 300, 400, 500, 600 von Festkörperschaltern die elektrischen Ströme mit unterschiedlichen Phasenlagen anregen. Die Festkörperschalter einer jeder einzelnen Gruppe 300, 400, 500, 600 müssen den elektrischen Strom dabei synchron zueinander schalten.

Der HF-Generator 100 weist eine nur schematisch dargestellte Phasenkontrolleinrichtung 110 auf, die dazu ausgebildet ist, eine Mehrzahl von Phasenkontrollsignalen 111, 112, 113, 114 zu erzeugen. Die Phasenkontrollsignale 111, 112, 113, 114 weisen jeweils die gleiche Frequenz, jedoch voneinander abweichende Phasenlagen auf. Das erste Phasenkontrollsignal 111 wird der ersten Gruppe 300 von Festkörperschaltern zugeführt. Das zweite Phasenkontrollsignal 112 wird der zweiten Gruppe 400 von Festkörperschaltern zugeführt. Das dritte Phasenkontrollsignal 113 wird der dritten Gruppe 500 von Festkörperschaltern zugeführt. Das vierte Phasenkontrollsignal 114 wird der vierten Gruppe 600 von Festkörperschaltern zugeführt. Falls der HF-Generator 100 weitere Gruppen von Festkörperschaltern umfasst, die über weiteren Schlitzen der Wandung 250 des Hohlleiters 200 angeordnet sind, so gibt die Phasenkontrolleinrichtung 110 weitere Phasenkontrollsignale aus, die den weitere Gruppen von Festkörperschaltern zugeführt werden.

Jeder der Festkörperschalter der Gruppen 300, 400, 500, 600 ist dazu ausgebildet, die von ihm über die Ausgangsanschlüsse 311, 312 ausgegebene Spannung synchron zu dem ihm zugeführten Phasenkontrollsignal 111, 112, 113, 114 zu schalten. Die Festkörperschalter der ersten Gruppe 300 regen in der Wandung 250 also einen elektrischen Strom synchron zum ersten Phasenkontrollsignal 111 an. Die Festkörperschalter der zweiten Gruppe 400 regen einen elektrischen Strom synchron zum zweiten Phasenkontrollsignal 112 an. Die Festkörperschalter der dritten Gruppe 500 und der vierten Gruppe 600 verhalten sich entsprechend.

Durch die Wahl der Positionen, an denen die Schlitze 210, 220, 230, 240 in der Wandung 250 des Hohlleiters 200 vorgesehen sind und durch die Wahl der Phasenbeziehungen der Phasenkontrollsignale 111, 112, 113, 114 zueinander wird festgelegt, welche Schwingungsmode im Hohlleiter 200 des HF-Generators 100 angeregt werden kann.

Es ist ebenfalls möglich, anstelle der getrennten Schlitze 210 und 220 bzw. 230 und 240 jeweils einen einzigen durchgehenden Schlitz auf jeder Seite des Hohlleiters 200 vorzusehen. An jedem der Schlitze können dann eine oder mehrere Gruppen von Festkörperschaltern angeordnet sein.

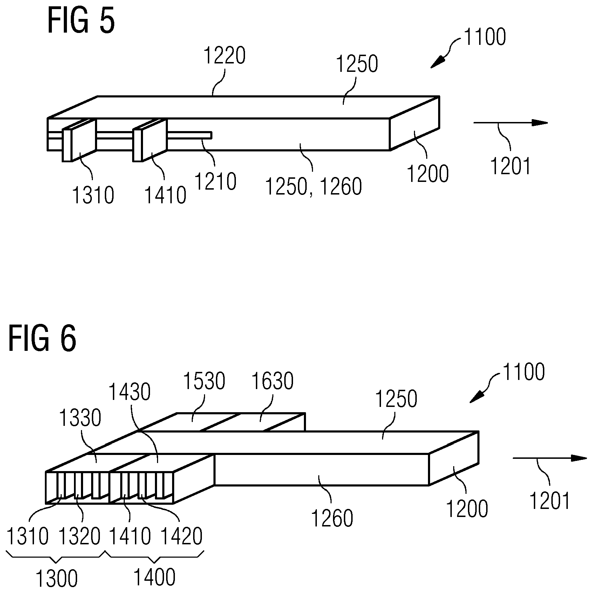

Figur 5 zeigt eine schematische perspektivische Darstellung eines HF-Generators 1100 gemäß einer zweiten Ausführungsform. Der HF-Generator 1100 dient zur Erzeugung hochfrequenter elektromagnetischer Wellen mit hoher Leistung. Auch die durch den HF-Generator 1100 erzeugte HF-Leistung kann beispielsweise in einem Teilchenbeschleuniger zur Beschleunigung geladener Teilchen genutzt werden.

Der HF-Generator 1100 umfasst einen Hohlleiter 1200, der im Wesentlichen hohlzylindrisch ausgebildet ist und aus einem elektrisch leitenden Material, bevorzugt aus einem Metall, besteht. Die axiale Richtung des zylindrischen Hohlleiters 1200 legt eine Längsrichtung 1201 fest. Der Hohlleiter 1200 weist einen rechteckigen Querschnitt auf.

Eine Mantelfläche des zylindrischen Hohlleiters 1200 wird durch eine Wandung 1250 gebildet. Wird in dem Hohlleiter 1200 eine elektromagnetische Schwingungsmode angeregt, so fließen in der Wandung 1250 orts- und zeitabhängige elektrische Ströme, deren räumlicher und zeitlicher Verlauf sich berechnen lässt und unter Fachleuten bekannt ist.

An einer in Längsrichtung 1201 verlaufenden Schmalseite 1260 des Hohlleiters 1200 weist die Wandung 1250 einen ersten Schlitz 1210 auf. Eine in Figur 5 nicht sichtbare, der Schmalseite 1260 gegenüberliegende, weitere Schmalseite des Hohlleiters 1200 weist einen dritten Schlitz 1230 auf. Der erste Schlitz 1210 und der dritte Schlitz 1230 verlaufen beide in Längsrichtung 1201. Wird im Hohlleiter 1200 eine elektromagnetische Schwingungsmode angeregt, so fließen in der Wandung 1250 des Hohlleiters 1200 elektrische Ströme, die senkrecht zu den Schlitzen 1210, 1230 orientiert sind. Umgekehrt können durch Anregung von senkrecht zu den Schlitzen 1210, 1230 verlaufenden elektrischen Strömen in der Wandung 1250 elektrische Schwingungsmoden im Hohlleiter 1200 angeregt werden.

Figur 6 zeigt, dass am ersten Schlitz 1210 eine erste Gruppe 1300 von Festkörperschaltern angeordnet ist, die einen ersten Festkörperschalter 1310, einen zweiten Festkörperschalter 1320 und weitere Festkörperschalter umfasst. Die erste Gruppe 1300 von Festkörperschaltern 1310, 1320 ist in einem ersten Schirmgehäuse 1330 angeordnet, das die erste Gruppe 1300 von Festkörperschaltern vollständig umschließt. Außerdem ist am ersten Schlitz 1210 eine zweite Gruppe 1400 von Festkörperschaltern angeordnet, die einen dritten Festkörperschalter 1410, einen vierten Festkörperschalter 1420 und weitere Festkörperschalter umfasst. Die zweite Gruppe 1400 von Festkörperschaltern 1410, 1420 ist in einem zweiten Schirmgehäuse 1430 angeordnet, das die Festkörperschalter 1410, 1420 der vierten Gruppe 1400 in alle Raumrichtungen umschließt. Entsprechend sind am dritten Schlitz 1230 eine dritte Gruppe 1500 von Festkörperschaltern in einem dritten Schirmgehäuse 1530 und eine vierte Gruppe 1600 von Festkörperschaltern in einem vierten Schirmgehäuse 1630 angeordnet.

Im Unterschied zum HF-Generator 100 der ersten Ausführungsform sind beim HF-Generator 1100 der zweiten Ausführungsform somit an jedem Schlitz 1210, 1230 mehrere Gruppen 1300, 1400, 1500, 1600 von Festkörperschaltern angeordnet. Alternativ wäre es jedoch auch möglich, anstelle des ersten Schlitzes 1210 zwei getrennte Schlitze vorzusehen und die erste Gruppe 1300 am ersten dieser Schlitze und die zweite Gruppe 1200 am zweiten dieser Schlitze anzuordnen. Auch der dritte Schlitz 1230 könnte entsprechend durch zwei oder mehr getrennte Schlitze ersetzt werden. Es wäre ebenfalls möglich, am ersten Schlitz 1210 und am dritten Schlitz 1230 jeweils mehr als zwei Gruppen von Festkörperschaltern vorzusehen. Jede der Gruppen 1300, 1400, 1500, 1600 kann eine beliebige Anzahl von Festkörperschaltern umfassen.

Die Festkörperschalter des HF-Generators 1100 der zweiten Ausführungsform entsprechen in Aufbau und Funktionsweise denen des HF-Generators 100 der ersten Ausführungsform.

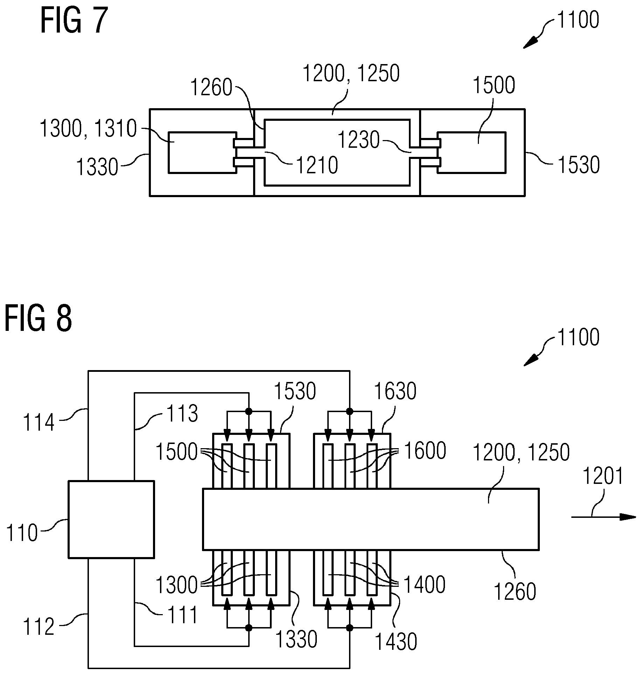

Figur 7 zeigt in schematischer Darstellung einen Schnitt durch den HF-Generator 1100. Erkennbar ist, dass jeder der Festkörperschalter der Gruppen 1300, 1400, 1500, 1600 mit Abschnitten der Wandung 1250 auf beiden Seiten des der jeweiligen Gruppe 1300, 1400, 1500, 1600 zugeordneten Schlitzes 1210, 1230 verbunden ist, um eine hochfrequente elektrische Spannung über den jeweiligen Schlitz 1210, 1230 anzulegen. Der Aufbau des HF-Generators 1100 entspricht insoweit dem des HF-Generators 100 der ersten Ausführungsform.

Figur 8 zeigt eine schematische Aufsicht auf den HF-Generator 1100. Erkennbar ist der Hohlleiter 1200 mit der ersten Gruppe 1300 von Festkörperschaltern 1310, 1320, der zweiten Gruppe 1400 von Festkörperschaltern 1410, 1420, der dritten Gruppe 1500 von Festkörperschaltern und der vierten Gruppe 1600 von Festkörperschaltern.

Der HF-Generator 1100 weist außerdem die Phasenkontrolleinrichtung 110 auf, die bereits im Zusammenhang mit dem HF-Generator 100 der ersten Ausführungsform erläutert wurde. Die in der Wandung 1250 des Hohlleiters 1200 fließenden elektrischen Ströme sind orts- und zeitabhängig. Wird in dem Hohlleiter 1200 beispielsweise eine TE10-Schwingungsmode angeregt, so ist der am Ort der ersten Gruppe 1300 von Festkörperschaltern fließende elektrische Strom zu jedem Zeitpunkt genau um 180° phasenversetzt gegenüber dem am Ort der zweiten Gruppe 1400 von Festkörperschaltern fließenden Strom. Entsprechendes gilt für die dritte Gruppe 1500 von Festkörperschaltern und die vierte Gruppe 1600 von Festkörperschaltern.

Die Phasenkontrolleinrichtung 110 ist dazu ausgebildet, die Phasenkontrollsignale 111, 112, 113, 114 zu erzeugen. Das erste Phasenkontrollsignal 111 wird der ersten Gruppe 1300 von Festkörperschaltern zugeführt. Das zweite Phasenkontrollsignal 112 wird der zweiten Gruppe 1400 von Festkörperschaltern zugeführt. Das dritte Phasenkontrollsignal 113 wird der dritten Gruppe 1500 von Festkörperschaltern zugeführt. Das vierte Phasenkontrollsignal 114 wird der vierten Gruppe 1600 von Festkörperschaltern zugeführt.

Die Phasenkontrollsignale 111, 112, 113, 114 weisen jeweils die gleiche Frequenz auf, sind jedoch gegeneinander phasenversetzt. Soll im Hohlleiter 1200 des HF-Generators 1100 beispielsweise eine TE10-Schwingungsmode angeregt werden, so sind das erste Phasenkontrollsignal 111 und das zweite Phasenkontrollsignal 112 um 180° gegeneinander versetzt. Entsprechend sind auch das dritte Phasenkontrollsignal 113 und das vierte Phasenkontrollsignal 114 um 180° gegeneinander phasenverschoben.

Die in den Hohlleitern 200, 1200 der HF-Generatoren 100, 1100 angeregte elektromagnetische Leistung wird durch die Hohlleiter 200, 1200 in Längsrichtung 201, 1201 transportiert. An einem Längsende des jeweiligen Hohlleiters 200, 1200 kann die elektromagnetische Leistung aus dem Hohlleiter 200, 1200 ausgekoppelt werden. Beispielsweise kann an einem Längsende des Hohlleiters 200, 1200 eine Kavität angeordnet sein, in die die durch den HF-Generator 100, 1100 erzeugte HF-Leistung eingekoppelt wird. Geeignete Koppelelemente sind aus dem Stand der Technik bekannt. Die durch den HF-Generator 100, 1100 erzeugte HF-Leistung kann auch in einem Teilchenbeschleuniger zur Beschleunigung geladener Teilchen verwendet werden. In diesem Fall kann der Hohlleiter 200, 1200 des HF-Generators 100, 1100 beispielsweise an eine Kavität des Teilchenbeschleunigers gekoppelt sein.

## Patentansprüche

1. HF-Generator (100, 1100)
mit einem Hohlleiter (200, 1200) mit einer leitfähigen Wandung (250, 1250), wobei die Wandung (250, 1250) einen ersten Schlitz (210, 1210) aufweist,
wobei ein erster Festkörperschalter (310, 1310) über dem ersten Schlitz (210, 1210) angeordnet ist, um eine hochfrequente elektrische Spannung über den ersten Schlitz (210, 1210) anzulegen.

2. HF-Generator (100) gemäß Anspruch 1,
wobei der Hohlleiter (200) einen kreisförmigen Querschnitt aufweist.

3. HF-Generator (1100) gemäß Anspruch 1,
wobei der Hohlleiter (1200) einen rechteckigen Querschnitt aufweist.

4. HF-Generator (1100) gemäß Anspruch 3,
wobei der HF-Generator (1100) ausgebildet ist, eine TE10-Schwingungsmode in dem Hohlleiter (1200) anzuregen.

5. HF-Generator (100, 1100) gemäß einem der vorhergehenden Ansprüche,
wobei der erste Festkörperschalter (310, 1310) in einem Schirmgehäuse (330, 1330) angeordnet ist.

6. HF-Generator (100, 1100) gemäß einem der vorhergehenden Ansprüche,
wobei der HF-Generator (100, 1100) eine Phasenkontrolleinrichtung (110) umfasst, die dazu ausgebildet ist, ein erstes Phasenkontrollsignal (111) zu erzeugen,
wobei der HF-Generator (100, 1100) ausgebildet ist, dem ersten Festkörperschalter (310, 1310) das erste Phasenkontrollsignal (111) zuzuführen.

7. HF-Generator (100, 1100) gemäß einem der vorhergehenden Ansprüche,
wobei ein zweiter Festkörperschalter (320, 1320) über dem ersten Schlitz (210, 1210) angeordnet und dem ersten Festkörperschalter (310, 1310) parallel geschaltet ist.

8. HF-Generator (100, 1100) gemäß Anspruch 7,
wobei der erste und der zweite Festkörperschalter (310, 320, 1310, 1320) in einem gemeinsamen Schirmgehäuse (330, 1330) angeordnet sind.

9. HF-Generator (100, 1100) gemäß Anspruch 6 und einem der Ansprüche 7 oder 8,
wobei der HF-Generator (100, 1100) ausgebildet ist, auch dem zweiten Festkörperschalter (320, 1320) das erste Phasenkontrollsignal (111) zuzuführen.

10. HF-Generator (100) gemäß einem der vorhergehenden Ansprüche,
wobei die Wandung (250) einen zweiten Schlitz (220) aufweist,
wobei ein dritter Festkörperschalter (410) über dem zweiten Schlitz (220) angeordnet ist.

11. HF-Generator (1100) gemäß einem der Ansprüche 1 bis 9,
wobei ein dritter Festkörperschalter (1410) über dem ersten Schlitz (1210) angeordnet und dem ersten Festkörperschalter (310, 1310) parallel geschaltet ist.

12. HF-Generator (100, 1100) gemäß einem der Ansprüche 10 oder 11,
wobei der dritte Festkörperschalter (410, 1410) in einem zweiten Schirmgehäuse (430, 1430) angeordnet ist.

13. HF-Generator (100, 1100) gemäß einem der Ansprüche 6 bis 9 und einem der Ansprüche 10 bis 12,
wobei die Phasenkontrolleinrichtung (110) ferner ausgebildet ist, ein zweites Phasenkontrollsignal (112) zu erzeugen,
wobei der HF-Generator (100, 1100) ausgebildet ist, dem dritten Festkörperschalter (410, 1410) das zweite Phasenkontrollsignal (112) zuzuführen.

14. HF-Generator (1100) gemäß Anspruch 13,
wobei die Phasenkontrolleinrichtung (110) ausgebildet ist, das erste Phasenkontrollsignal (111) und das zweite Phasenkontrollsignal (112) mit einer Phasenverschiebung von 180° zueinander zu erzeugen.

15. HF-Generator (100, 1100) gemäß einem der vorhergehenden Ansprüche,
wobei der Hohlleiter (200, 1200) an eine Kavität gekoppelt ist.

16. Teilchenbeschleuniger mit einem HF-Generator (100, 1100) gemäß einem der vorhergehenden Ansprüche.

## Claims

1. RF generator (100, 1100)
comprising a hollow conductor (200, 1200) having a conductive wall (250, 1250),
wherein
the wall (250, 1250) comprises a first slot (210, 1210), a first solid-state switch (310, 1310) being arranged over the first slot (210, 1210) in order to apply a radiofrequency electrical voltage through the first slot (210, 1210).

2. RF generator (100) according to Claim 1,
wherein the hollow conductor (200) has a circular cross section.

3. RF generator (1100) according to Claim 1,
wherein the hollow conductor (1200) has a rectangular cross section.

4. RF generator (1100) according to Claim 3,
wherein the RF generator (1100) is formed so as to excite a TE10 resonant mode in the hollow conductor (1200).

5. RF generator (100, 1100) according to one of the preceding claims,
wherein the first solid-state switch (310, 1310) is arranged in a shielding housing (330, 1330).

6. RF generator (100, 1100) according to one of the preceding claims,
wherein the RF generator (100, 1100) comprises a phase control device (110) which is formed so as to generate a first phase control signal (111), the RF generator (100, 1100) being formed so as to deliver the first phase control signal (111) to the first solid-state switch (310, 1310) .

7. RF generator (100, 1100) according to one of the preceding claims,
wherein a second solid-state switch (320, 1320) is arranged over the first slot (210, 1210) and is connected in parallel with the first solid-state switch (30, 1310).

8. RF generator (100, 1100) according to Claim 7,
wherein the first and second solid-state switches (310, 320, 1310, 1320) are arranged in a common shielding housing (330, 1330).

9. RF generator (100, 1100) according to Claim 6 and one of Claims 7 and 8,
wherein the RF generator (100, 1100) is formed so as to deliver the first phase control signal (111) to the second solid-state switch (320, 1320) as well.

10. RF generator (100) according to one of the preceding claims,
wherein the wall (250) comprises a second slot (220), and wherein a third solid-state switch (410) is arranged over the second slot (220).

11. RF generator (1100) according to one of Claims 1 to 9,
wherein a third solid-state switch (1410) is arranged over the first slot (1210) and is connected in parallel with the first solid-state switch (310, 1310).

12. RF generator (100, 1100) according to one of Claims 10 and 11,
wherein the third solid-state switch (410, 1410) is arranged in a second shielding housing (430, 1430).

13. RF generator (100, 1100) according to one of Claims 6 to 9 and one of Claims 10 to 12,
wherein the phase control device (110) is furthermore formed so as to generate a second phase control signal (112),
the RF generator (100, 1100) being formed so as to deliver the second phase control signal (112) to the third solid-state switch (410, 1410).

14. RF generator (1100) according to Claim 13,
wherein the phase control device (110) is formed so as to generate the first phase control signal (111) and the second phase control signal (112) with a phase shift of 180° with respect to one another.

15. RF generator (100, 1100) according to one of the preceding claims,
wherein the hollow conductor (200, 1200) is coupled to a cavity.

16. Particle accelerator comprising an RF generator (100, 1100) according to one of the preceding claims.

## Revendications

1. Générateur HF (100,1100) comprenant un guide d'ondes (200, 1200) comprenant une paroi conductrice (250, 1250) ;
dans lequel la paroi (250, 1250) présente une première fente (210, 1210) ;
dans lequel un premier commutateur à semi-conducteurs (310, 1310) est disposé par-dessus la première fente (210, 1210) dans le but d'appliquer une tension électrique à haute fréquence par-dessus la première fente (210, 1210).

2. Générateur HF (100) selon la revendication 1,
dans lequel le guide d'ondes (200) présente une section transversale de forme circulaire.

3. Générateur HF (1100) selon la revendication 1,
dans lequel le guide d'ondes (1200) présente une section transversale de forme rectangulaire.

4. Générateur HF (1100) selon la revendication 3,
dans lequel le générateur HF (1100) est réalisé afin d'amorcer un mode d'oscillation TE10 dans le guide d'ondes (1200).

5. Générateur HF (100, 1100) selon l'une quelconque des revendications précédentes, dans lequel le premier commutateur à semi-conducteurs (310, 1310) est disposé dans un blindage (330, 1330).

6. Générateur HF (100,1100) selon l'une quelconque des revendications précédentes, dans lequel le générateur HF (100, 1100) comprend un mécanisme de réglage de phase (110) qui est réalisé pour générer un premier signal de réglage de phase (111) ;
dans lequel le générateur HF (100, 1100) est réalisé pour acheminer au premier commutateur à semi-conducteurs (310, 1310) le premier signal de réglage de phase (111).

7. Générateur HF (100,1100) selon l'une quelconque des revendications précédentes, dans lequel un deuxième commutateur à semi-conducteurs (320, 1320) est disposé par-dessus la première fente (210, 1210) et est monté parallèlement au premier commutateur à semi-conducteurs (310, 1310).

8. Générateur HF (100,1100) selon la revendication 7,
dans lequel le premier et le deuxième commutateur à semi-conducteurs (310, 320, 1310, 1320) sont disposés dans un blindage commun (330, 1330).

9. Générateur HF (100,1100) selon la revendication 6 et l'une quelconque des revendications 7 ou 8,
dans lequel le générateur HF (100, 1100) est réalisé pour acheminer le premier signal de réglage de phase (111) également au deuxième commutateur à semi-conducteurs (320, 1320).

10. Générateur HF (100) selon l'une quelconque des revendications précédentes, dans lequel la paroi (250) présente une deuxième fente (220) ;
dans lequel un troisième commutateur à semi-conducteurs (410) est disposé par-dessus la deuxième fente (220).

11. Générateur HF (1100) selon l'une quelconque des revendications 1 à 9,
dans lequel un troisième commutateur à semi-conducteurs (1410) est disposé par-dessus la première fente (1210) et est monté parallèlement au premier commutateur à semi-conducteurs (310, 1310).

12. Générateur HF (100,1100) selon l'une des revendications 10 ou 11,
dans lequel le troisième commutateur à semi-conducteurs (410, 1410) est disposé dans un deuxième blindage (430, 1430).

13. Générateur HF (100,1100) selon l'une quelconque des revendications 6 à 9 et l'une quelconque des revendications 10 à 12,
dans lequel le mécanisme de réglage de phase (110) est en outre réalisé pour générer un deuxième signal de réglage de phase (112) ;
dans lequel le générateur HF (100, 1100) est réalisé pour acheminer le deuxième signal de réglage de phase (112) au troisième commutateur à semi-conducteurs (410, 1410).

14. Générateur HF (1100) selon la revendication 13,
dans lequel le mécanisme de réglage de phase (110) est réalisé pour générer le premier signal de réglage de phase (111) et le deuxième signal de réglage de phase (112) avec un décalage de phase de 180° l'un par rapport à l'autre.

15. Générateur HF (100, 1100) selon l'une quelconque des revendications précédentes, dans lequel le guide d'ondes (200, 1200) est couplé à une cavité.

16. Accélérateur de particules comprenant un générateur HF (100, 1100) selon l'une quelconque des revendications précédentes.
